# EUROPEAN PATENT SPECIFICATION

(11) **EP 3 683 831 B1**
(45) Date of publication and mention of the grant of the patent: **04.12.2024**
(21) Application number: 19151780.4
(22) Date of filing: 15.01.2019
(51) Int. Cl.: H01L 23/373, C08K 3/34, C08K 3/22, C08K 3/28, C08K 3/38, C08K 7/14

(54) **INTERFACE MATERIAL COMPRISING A POLYMER CERAMIC**
SCHNITTSTELLENMATERIAL MIT EINER POLYMEREN KERAMIK
MATÉRIAU D'INTERFACE COMPRENANT UNE CÉRAMIQUE POLYMÈRE

(43) Date of publication of application: 22.07.2020
(73) Proprietor: Infineon Technologies AG, 85579 Neubiberg (DE)
(72) Inventor: Schwab, Stefan, 93053 Regensburg (DE); Mayer, Martin, 93152 Nittendorf (DE)
(74) Representative: Dilg, Haeusler, Schindelmann Patentanwaltsgesellschaft mbH

(56) References cited:
- EP-A1- 2 312 593
- US-A1- 2006 067 055
- US-A1- 2014 262 192
- US-A1- 2016 088 720
- US-A1- 2017 117 208

## Description

### Background

### Technical Field

Various embodiments relate generally to an assembly unit, an electronic component, a method of manufacturing an electronic component, and a method of using an interface material layer.

### Description of the related art

A conventional electronic chip mounted on a chip carrier such as a leadframe, electrically connected by a bond wire extending from the chip to the chip carrier, and molded within a package may suffer from its thermal insulation within the package. Furthermore, such a conventional approach can reach its limits when complex electronic circuits shall be established. For chip packages, the operation performance is limited in general by the amount of heat, which can be transferred to a cooling unit (such as a heat dissipation body) on board level.

Therefore, thermal interface materials (TIM) are used as interface material between the package (copper surface) and a cooling unit. A conventionally used TIM may however lack sufficient electrical isolation and is often not reliable in the way that during operation cycles its thermomechanical stability can be affected.

Moreover, it is possible to use thermal interface material in form of an attachable foil. Conventional thermal interface foils may have a high price and may involve an additional assembly effort.

US 2017/0117208 A1 discloses an assembly unit according to the preamble of claim 1.

US 2014/0262192 A1 discloses an assembly unit for coupling with an electronic chip of an electronic component, the assembly unit comprising a base body; an electrically insulating and thermally conductive interface structure attached to the base body and comprising an Ag-filled and ceramic-filled epoxy-based materials including flexible epoxies.

US 2006/0067055 A1 discloses an assembly unit for coupling with an electronic chip of an electronic component, the assembly unit comprising a base body; an electrically insulating and thermally conductive interface structure attached to the base body and comprising thermally conductive composites, such as epoxies with fused silica filler.

US 2016/0088720 A1 discloses an electronic device mounting technique in which insulative and thermal barrier materials used in combination with printed circuit board design produce higher electrical breakdown voltage while minimizing thermal resistance and electromagnetic interference.

EP 2 312 593 A1 discloses an insulating layer which is formed by curing an insulating sheet. Such insulating sheet comprises: a polymer; at least one of an epoxy resin; a curing agent; and at least one of magnesium carbonate anhydrous represented by MgCO₃ and containing no crystal water and a coated body obtainable by coating the surface of the magnesium carbonate anhydrous with an organic resin, a silicone resin, or silica.

As a result, conventional electronic components or packages may suffer from limited reliability.

### Summary

It is the object to provide an assembly unit, an electronic component, a method of manufacturing an electronic component, and a method of using an interface material layer offering a possibility to package an electronic chip with higher reliability. This object is achieved by the assembly unit having the features of claim 1, an electronic component having the features of claim 6, a method of manufacturing an electronic component having the features of claim 8, and a method of using an interface material layer having the features of claim 13.

According to an exemplary embodiment, an assembly unit for coupling with (in particular for thermally and/or mechanically and/or electrically and/or dielectrically coupling) an electronic chip of an electronic component is provided, wherein the assembly unit comprises a base body, and an electrically insulating and thermally conductive interface structure attached to the base body and comprising a polymer ceramic. A coefficient of thermal expansion of the cured polymer ceramic is in a range between 7 ppm/K and 30 ppm/K, in particular in a range between 10 ppm/K and 20 ppm/K.

According to another exemplary embodiment, an electronic component (such as a package) is provided which comprises an assembly unit having the above-mentioned features, and an electronic chip on or above the assembly unit.

According to another exemplary embodiment, a method of manufacturing an electronic component is provided, wherein the method comprises forming an (in particular layer-shaped) electrically insulating and thermally conductive interface structure comprising a polymer ceramic, connecting the interface structure with a base body, and thermally coupling an electronic chip with the interface structure. The method comprises curing a preform of the polymer ceramic to thereby at least partially cross-link a polymer within which ceramic filler particles are contained. A precursor of the polymer may for instance be in liquid and/or powder and/or pellet form prior to curing. The preform of the polymer may comprise monomers, oligomers, etc. The preform may be not yet polymerized or may be partially polymerized. The preform of the polymer may be cured by heating it to an appropriate temperature, for instance in a range between 250°C and 350°C, for example 300°C. Curing may result in a cross-linking of the polymer.

The method further comprises carrying out the curing so that the cross-linked polymer is partially, but not entirely converted into a ceramic material. The curing procedure may be continued until cross-linking is completed. Highly advantageously, the curing procedure may however be continued to an adjustable degree after completing cross-linking. Descriptively speaking, this may result in a partial transition of the cured or cross-linked polymer into a ceramic-type material. However, it is preferred that not a complete transition of the cured polymer into ceramic is carried out, but only a partial transition. This can be easily adjusted by correspondingly controlling the curing temperature. Advantageously, the properties of the obtained polymer ceramic may therefore be adjusted, since these properties depend sensitively on the degree of post-curing, i.e. on the degree of converting the cured polymer into a material with ceramic properties. Such a post-curing procedure may intentionally at least partially destroy the polymeric order and transfer the latter into a ceramic order.

Curing and post-curing may be carried out in one common procedure (for instance by heating the preform in an oven at an appropriate temperature) or in two separate subsequent procedures, one for curing and the other one for post-curing.
Before curing, the precursor of the polymer ceramic may be brought in the proper shape, for instance by pressing or molding.

According to another exemplary embodiment, an interface material layer comprising a polymer ceramic is used for providing an electric isolation and a thermal coupling of an electronic chip of an electronic component.

According to an exemplary embodiment, an assembly unit is provided which may form part of a package or electronic component packaging an electronic chip and which may have an interface structure made of a polymer ceramic. A coefficient of thermal expansion of the cured polymer ceramic is in a range between 7 ppm/K and 30 ppm/K, in particular in a range between 10 ppm/K and 20 ppm/K.

Correspondingly, an electronic component or package is provided having an interface material which is made of a polymer ceramic material. Such a polymer ceramic may be considered as a hybrid material combining properties of a polymeric material with those of a ceramic material. The polymer material has the advantage of being impact resistant and being thus able to compensate the risk of brittle failure of the ceramic. These advantages of the polymer can be synergistically combined with the advantage of the ceramic of having a high temperature stability while simultaneously being capable of significantly increasing thermal conductivity of the interface structure. Furthermore, such a polymer ceramic may be used for electrically insulating an electrically conductive portion of the electronic component (such as a chip carrier) with regard to the electronic periphery. At the same time, polymer ceramic materials show a high thermal conductivity so that they can also significantly contribute to the removal of heat out of an interior of the package or electronic component. Furthermore, polymer ceramic materials have excellent properties concerning robustness and thus allow using the electronic component with the electronic chip also in a harsh environment, for instance for automotive applications. A corresponding polymer ceramic may cross-link during curing and may therefore establish a hard and reliable connection with a base body of the assembly unit, and with other elements of the electronic component. Moreover, by correspondingly adjusting process parameters during curing the interface material of polymer ceramic, properties of the interface material can be adjusted in accordance with a target behavior in or of the electronic component. For instance, such an adjustment may be made in terms of electric isolation, thermal conductivity, and/or mechanical robustness. In particular advantageous may be an adjustment made in terms of the coefficient of thermal expansion of the interface material which can for instance be approached during curing to a corresponding value of the coefficient of thermal expansion of the material of the base body. This may decrease the tendency of thermal stress acting on the electronic component for instance in the presence of thermal cycles. As a consequence, the risk of cracks in the electronic component can be significantly decreased.

According to an exemplary embodiment, the mentioned polymer ceramic material may be used as a constituent of an assembly unit, which may be used, in turn, for providing an electronic component or package. One example for such an assembly unit is a heat dissipation body covered with a polymer ceramic interface structure. Such an assembly unit can be connected with an encapsulated electronic chip mounted on a chip carrier so as to further promote removal of heat out of an interior of the electronic component. Such heat may be generated by the encapsulated electronic chip, for instance a semiconductor die, during operation. In another embodiment, such an assembly unit may be a multi-layer (for instance double-layer or triple layer) carrier structure comprising at least the base body and the interface structure, and for instance an additional carrier structure. Such assembly units may be used as constituent of an electronic component or any other system. Due to the outstanding properties of a polymer ceramic interface structure, it is therefore possible to efficiently promote heat removal out of the electronic component while simultaneously ensuring a reliable electric insulation and a high mechanical robustness.

### Description of further exemplary embodiments

In the following, further exemplary embodiments of the assembly unit, the electronic component, the method of manufacturing an electronic component, and the method of use will be explained.

In the context of the present application, the term "assembly unit" may particularly denote any element or constituent on the basis of which an electronic component, a package, a system or the like may be constructed.

In the context of the present application, the term "electronic component" may particularly denote a package comprising one or more electronic chips packaged using one or more assembly units. Optionally, also an encapsulant and/or one or more electrically conductive contact elements (such as bond wires or clips) may be implemented in an electronic component.

In the context of the present application, the term "interface structure" may particularly denote any physical structure forming an interface between any constituents or bodies of an electronic component, a package, a system or the like.

In the context of the present application, the term "polymer" may particularly denote a substance made of molecules being composed of a plurality of repeated subunits. Polymers may be created by polymerization of multiple smaller molecules (which may be denoted as monomers, etc.). Polymerization may denote a process of reacting monomer molecules together in a chemical reaction to form polymer chains or three-dimensional networks. A polymer may be a material which is capable of cross-linking.

In the context of the present application, the term "ceramic" may particularly denote a technical ceramic. Such technical ceramics may have the properties according to ENV 12212 (in the most recent version at the priority date of the present application). In particular, the ceramic may be a highly developed, high-performance applicable ceramic material, which may be mainly non-metallic and inorganic and may have certain functional properties. In particular, the term "ceramic" in the scope of this disclosure may encompass all listed ceramic types of ENV 12212: C 111, C 112, C 120, C 130, C 140, C 210, C 221, C 221, C 230, C 240, C 250, C 410, C 420, C 430, C 440; C 510, C 511, C 512, C 520, C 530, C 610, C 620, C 310; C 320, C 330, C 331, C 340, C 350, C 351, C 780, C 786, C 795, C 799, RBAO (denoting a term according to DIN ENV 14 242), C 810, C 820, MgO (denoting a term according to DIN ENV 14 242), PSZ (denoting a term according to DIN ENV 14 242), FSZ (denoting a term according to DIN ENV 14 242), TZP (denoting a term according to DIN ENV 14 242), ATI (denoting a term according to DIN ENV 14 242), PZT (denoting a term according to DIN ENV 14 242), SiO2 (denoting a term according to DIN ENV 14 242), TiO2 (denoting a term according to DIN ENV 14 242). Also Spinel or Mullite materials, both denoting commonly used engineering terms, may be covered by the term "ceramic". In the context of the present application, the term "polymer ceramic" may particularly denote (for instance inorganic-organic) composites comprising or consisting of ceramic fillers and a polymers, particularly polysiloxanes. The formation of polymer ceramics may be based on thermal curing of functionalized resins being able to form ceramic-like structures as a result of a heat treatment, for instance above 200°C. Relevant usage properties (for example electric insulation, thermal conductivity, coefficient of thermal expansion, hardness) and processing parameters can be adjusted by the choice of appropriate functional fillers, binder systems, and/or (for example plasticizing) additives. For instance, polymer-ceramic composites may be prepared via melt extrusion using high-density polyethylene and low-density polyethylene coated BaO-Nd₂O₃-TiO₂ ceramic-powders as the filler.

In the context of the present application, the term "thermal conductivity" may particularly denote a capability of the material of the interface structure itself defining how much thermal energy can be conducted or removed via the interface material per distance and per temperature difference between a source and a drain of the thermal energy.

In an embodiment, the interface structure consists of the polymer ceramic. In other words, it is possible according to an exemplary embodiment to manufacture the interface structure exclusively as a polymer ceramic, i.e. without further constituents. It has turned out that a polymer ceramic alone is sufficient for serving as interface structure. Therefore, the thermal interface material may be manufactured in a simple way. It is however alternatively possible that the interface structure comprises one or more constituents in addition to the polymer and the ceramic, for instance additives.

In an embodiment, the polymer ceramic comprises a polymer mixed with ceramic filler particles. Thus, the polymer ceramic may be a filled polymer ceramic.

The polymer material may be in particular a material which can be converted into a ceramic material at very high temperatures (for instance polysiloxane). Within the polymer, the remaining constituents of the interface structure may be mixed. In other words, the polymer may be a substance in which the other constituents of the interface structure, in particular the filler particles, are embedded.

In the context of the present application, the term "filler particles" may particularly denote a (in particular powderous or granulate-type) substance filling out interior volumes in the polymer. By the selection of the filler particles, the physical and/or chemical properties of the interface structure can be adjusted. Such properties may include the coefficient of thermal expansion, the thermal conductivity, the dielectric properties, etc. The filler particles may or may not be coated with a coating, for instance with the polymer and/or with an adhesion promoter. By such a coating or in any other way, the filler particles may be functionalized in accordance with a function to be fulfilled by the interface structure.

Thus, an exemplary embodiment provides a polymer ceramic with a polymer in which filler particles of ceramic nature are embedded. The polymer in an uncured state can be selectively and adjustably cured by triggering cross-linking of the polymer of the polymer ceramic. The degree of curing may be used as a design parameter for a fine adjustment of the properties of the obtained polymer ceramic, for instance in terms of its coefficient of thermal expansion. The ceramic filler particles, a second constituent of the polymer ceramic, can be selected specifically so that the physical properties of the interface structure can be adjusted correspondingly. For instance, the filler particles may be selected for increasing the thermal conductivity, the electrically insulating property and/or the mechanical robustness. In particular, silicon organic polymers have turned out as properly compatible with the requirements of an interface structure.

In an embodiment, the polymer (in particular a silicon organic polymer) may comprise at least one of the group consisting of polysiloxane, polycarbosilane, polysilazane, and polyborosilazane. More precisely, such materials may be used as precursor materials of the readily manufactured and cured polymer ceramic. In view of its advantageous properties for electronic components packaging an electronic chip, polysiloxane is an advantageous option.

In an embodiment, the ceramic filler particles (which may be in particular inorganic filler particles) may comprise at least one of the group consisting of oxide ceramic, nitride ceramic, and boron ceramic. Also a silicate ceramic or a carbide ceramic may be implemented. Filler particles (such as SiO₂, Al₂O₃, Si₃N₄, BN, AlN, diamond, etc.), for instance for improving thermal conductivity, may be embedded in a polymer base of the interface structure. However, other filler particles may be implemented in the interface structure as well, in addition or alternatively to the mentioned filler particles. In particular, filler particles may be provided as nanoparticles or microparticles. Filler particles may have identical dimensions or may be provided with a distribution of particle sizes (in particular, the filler particles may be two or more distributions with two or more different mean values of particle sizes). Such a particle size distribution may be preferred since it may allow for an improved filling of gaps in an interior of the interface structure. For instance, a dimension of the filler particles may be in the range between 1 nm and 200 pm, in particular in a range between 10 nm and 20 pm, more particularly in a range between 2 µm and 5 µm. For instance, the shape of the filler particles may be randomly, spherical, cuboid-like, flake-like, and film-like.

In particular, the filler particles may be selected from a group consisting of crystalline silica, fused silica, spherical silica, titanium oxide, aluminum oxide, aluminium hydroxide, magnesium hydroxide, zirconium dioxide, calcium carbonate, calcium silicate, talc, clay, carbon fiber, glass fiber and mixtures thereof. Other filler materials are however possible depending on the demands of a certain application.

In an embodiment, the electronic component comprises an intermediate layer (or multiple intermediate layers) between the base body and the interface structure. In particular, such an intermediate layer may be arranged between a chip carrier (such as a leadframe) and the polymer ceramic. For instance, the intermediate layer may be an adhesion promoting layer. Although in many cases, adhesion of the polymer ceramic on electrically conductive material of a carrier (in particular copper) is advantageously high, the mechanical reliability of the electronic component or the assembly unit may be further improved by locating an additional adhesion promoter between the material of the base body (for instance a carrier) and the polymer ceramic of the interface structure. As a consequence, the adhesion of the polymer ceramic may be further improved and the electronic component can be rendered even more robust. The adhesion promoter may be a chemical or mechanical adhesion promoter, for instance NiNiP. However, the intermediate layer may also be functionalized in another way than as an adhesion promoter. For example, the intermediate layer may be an ALD (Atomic Layer Deposition) layer (for example made of aluminum, copper oxide, chromium, etc.), a CVD (Chemical Vapor Deposition) layer, etc.

In an embodiment of the manufacturing method, the method comprises connecting a preformed (in particular already solid) platelet of the polymer ceramic to the base body. For example, a sheet of the polymer ceramic may be formed separately and may then be attached in a solid state onto the base body or onto a desired surface portion of the electronic component, in particular attached to an exposed surface portion of the base body and optionally also to an exposed surface portion of an encapsulant. This allows manufacturing the polymer ceramic in a batch procedure, for instance as a very large and very thin plate. This plate may then be singularized (for instance cut) into several small platelets. Each of the platelets may be picked and placed on a respective base body or on a desired surface portion of the electronic component. Such a manufacturing method is particularly efficient.

In an embodiment, the method comprises pressing the preformed platelet on the base body and subsequently triggering a reaction for connecting the platelet to the base body. For connecting a platelet of polymer ceramic to a target surface of the electronic component or the base body, the platelet may be simply pressed on the target surface so as to initiate a chemical reaction for connection purposes. For instance, such a connection may be established by curing an adhesive material. In an embodiment, the platelet may be sintered onto the base body.

In another embodiment, the method comprises applying a deformable (for instance not yet solidified) preform of the polymer ceramic to the base body and subsequently curing the preform to thereby form the polymer ceramic. For instance, this curing may be carried out within a molding tool or before a molding procedure. In the mentioned alternative embodiment, the preform of the polymer ceramic may be deformable and therefore applicable in a highly flexible way on any desired target surface of any desired shape. For instance, this may be accomplished by dispensing or printing. Thereafter, the deformable preform of the polymer ceramic applied to the base body may be cured (for instance thermally). By this curing, the previously deformable preform may be hardened so as to form a solid and indeformable polymer ceramic constituting the interface structure on the base body.

In an embodiment, the deformable preform can be in form of a liquid, a solution, and/or a paste. For instance, the preform may be a liquid polymer with ceramic filler particles therein. The liquid polymer may be configured so as to be hardenable by the application of heat and/or pressure, thereby curing the liquid polymer. The preform may however also be a solution of multiple constituents which become solid upon curing. A paste may comprise a solid component of small particles or powder which may both include the polymer and ceramic particles.

In an embodiment, the method comprises curing the preform by evaporating a solvent of the preform. For example, evaporation of a solvent of the aforementioned paste may render the latter solid. During the curing, thermal energy may be supplied which may evaporate the solvent of the preform. As a consequence, a solid polymer ceramic may be formed.

In an embodiment, the method comprises applying the preform by printing. Printing the polymer ceramic or its preform onto a target surface of the base body (and optionally also on a further body such as an encapsulant) has the significant advantage that such an application procedure is possible with substantially any shape of the target surface, even if its three-dimensionally curved in a complex way. By printing, also the amount of the polymer ceramic may be precisely adjusted, and therefore for instance a desired thickness which may be advantageous to ensure a high dielectric reliability.
contained. A precursor of the polymer may for instance be in liquid and/or powder and/or pellet form prior to curing. The preform of the polymer may comprise monomers, oligomers, etc. The preform may be not yet polymerized or may be partially polymerized. The preform of the polymer may be cured by heating it to an appropriate temperature, for instance in a range between 250°C and 350°C, for example 300°C. Curing may result in a cross-linking of the polymer.

In an embodiment, the method comprises carrying out the curing so that the cross-linked polymer is partially, but not entirely converted into a ceramic material. The curing procedure may be continued until cross-linking is completed. Highly advantageously, the curing procedure may however be continued to an adjustable degree after completing cross-linking. Descriptively speaking, this may result in a partial transition of the cured or cross-linked polymer into a ceramic-type material. However, it is preferred that not a complete transition of the cured polymer into ceramic is carried out, but only a partial transition. This can be easily adjusted by correspondingly controlling the curing temperature. Advantageously, the properties of the obtained polymer ceramic may therefore be adjusted, since these properties depend sensitively on the degree of post-curing, i.e. on the degree of converting the cured polymer into a material with ceramic properties. Such a post-curing procedure may intentionally at least partially destroy the polymeric order and transfer the latter into a ceramic order.

Curing and post-curing may be carried out in one common procedure (for instance by heating the preform in an oven at an appropriate temperature) or in two separate subsequent procedures, one for curing and the other one for post-curing. Before curing, the precursor of the polymer ceramic may be brought in the proper shape, for instance by pressing or

In particular, the method comprises controlling the curing (in particular a post-curing procedure after having completed a main curing procedure of cross-linking the polymer) so that a coefficient of thermal expansion (CTE) of the cured polymer ceramic becomes closer to a coefficient of thermal expansion of the base body. For example, the base body (for instance a leadframe) may be made of copper which has a CTE value of approximately 16 ppm/K. In such an embodiment, the curing may be completed to such a degree that the CTE value of the obtained interface structure is approached towards the CTE value of the base body.

In an embodiment, the method comprises controlling the curing so that a coefficient of thermal expansion of the cured polymer ceramic is in a range between 7 ppm/K and 30 ppm/K, in particular in a range between 10 ppm/K and 20 ppm/K. An interface structure with a CTE value in the mentioned ranges is sufficiently close to the CTE value of typical base body materials so that thermal stress can be strongly suppressed and the reliability of the obtained electronic component may be improved.

In an embodiment, the method comprises curing the preform by tempering to thereby trigger cross-linking of the preform. The application of heat is a simple and predictable way of triggering curing.

In an embodiment, the method comprises forming the polymer ceramic, in particular to cover the base body, before mounting the electronic chip on or above the base body. In particular, curing the polymer ceramic may be carried out before chip mounting on the base body so that the chip does not suffer from the high temperatures which may be involved in such a curing procedure. Therefore, any damage of the semiconductor chip may be avoided while simultaneously ensuring high thermal conductivity and reliable electric decoupling of the electronic chip by the interface structure.

In another embodiment, the method comprises forming the polymer ceramic, in particular to cover the base body, after mounting the electronic chip on or above the base body. When the electronic chip is not sensitive concerning temperature, it is also possible to apply the polymer ceramic based interface structure after chip mounting, and further preferred after encapsulation.

In an embodiment, the electronic component comprises an encapsulant encapsulating at least part of the assembly unit (in particular part of the base body) and/or at least part of the electronic chip. For instance, the encapsulant may comprise a mold compound. For the encapsulating, a plastic material or a ceramic material may be used. In other embodiments, a casing is used for encapsulation.

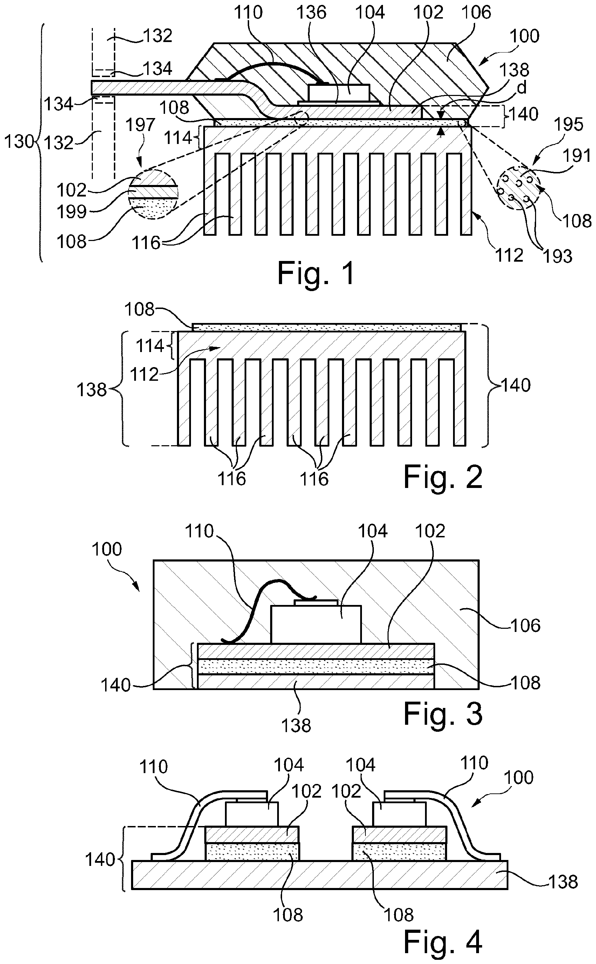

In an embodiment, the base body (on which the interface structure may be secured) is configured as a chip carrier (such as a leadframe) carrying the electronic chip (see for instance Figure 1). For example, the base body may be made of an electrically conductive material such as copper and/or aluminum.

In another embodiment, the base body (on which the interface structure may be secured) is configured as a heat dissipation body (see for instance Figure 2). For example, such a heat dissipation body may comprise a base plate integrally connected with a plurality of cooling fins. When the interface structure is connected to such a heat dissipation body, a stress between the heat dissipation body and a chip carrier (in particular a leadframe) of the electronic component can be significantly reduced.

In yet another embodiment, the base body may form part (in particular may be one layer) of a multi-layer carrier arrangement in which a layer of the interface structure is sandwiched between the base body and a further carrier (in particular a further carrier layer). Figure 3 and Figure 4 shows embodiments of assembly units composed as such multi-layer (in particular triple layer) stack carrier arrangements. In particular, the further carrier, the interface structure and the base body together may form a layer stack on which the electronic chip may be mounted. For instance, such an assembly unit may be constructed similar as a DCB (Direct Copper Bonding) or a DAB (Direct Aluminum Bonding) substrate, with the difference that the electrically insulating central layer or sheet may be made of the polymer ceramic interface structure.

In an embodiment, at least one of the further carrier and the interface structure is configured as patterned layer on the base body (compare for instance Figure 4). For example, a three-layer stack composed of base body, interface structure and carrier may be patterned so that the base body remains a continuous structure (for instance sheet), whereas the carrier and the interface structure are patterned (together or separately) into two or more separate mounting structures. For instance, a respective electronic chip may be mounted on each of these mounting structures. It is however also possible that only one mounting structure is equipped with an electronic chip. In yet another embodiment, the base body may be patterned and/or the carrier may be patterned, whereas the interface structure in between may remain continuous.

In an embodiment, the interface structure is configured as a sheet, in particular as a continuous or patterned layer having a thickness being smaller than the other spatial dimensions of the sheet. For example, such a sheet may be a planar sheet (i.e. a sheet lying within one plane) or a curved sheet (i.e. a three-dimensionally curved layer).

In an embodiment, the interface structure has a thickness in a range between 50 µm and 600 pm, in particular in a range 100 µm and 400 µm. For example, the interface structure may be a planar layer with a thickness of more than 150 pm, in particular of more than 200 pm, more particularly in a range between 70 µm and 300 µm. For example, the thickness may be 250 µm. Sufficiently high thicknesses of the thermal interface material allow for a reliable dielectric or electrically insulating separation. However, the thicker the interface structure, the stronger will the thermal energy removal capability of the interface structure be influenced. The given range allows obtaining both proper thermal conditions and electrical conditions at the same time. Also a scratch resistance may be ensured with the mentioned thicknesses even under harsh conditions.

In an embodiment, the interface structure has an electric breakdown voltage being sufficiently high to ensure dielectric reliability of the electronic component. In the context of the present application, the term "electric breakdown voltage" may particularly denote a value of an electric voltage applied to the interface material which voltage, when reached or exceeded, results in an electrical breakdown or dielectric breakdown of the interface material. Such an electric breakdown corresponds to a rapid reduction in the resistance of the (previously electrically insulating) interface material when the voltage applied across it exceeds the breakdown voltage. This results in at least a portion of the interface material becoming electrically conductive. In particular, the interface material may have an electric breakdown voltage (AC root mean square value) of at least 2 kV, in particular of at least 5 kV more particular in a range between 5 kV and 12 kV. However, in another embodiment, the electric breakdown voltage may be less, for instance for other applications than high-power applications.

In an embodiment, the interface structure has a thermal conductivity of at least 1 W m⁻¹ K⁻¹, in particular of at least 2 W m⁻¹ K-1 or, more particularly in a range between 3 W m⁻¹ K⁻¹ and 20 W m⁻¹ K⁻¹. For certain applications, the interface structure shall be properly electrically insulating and thermally conductive at the same time. To obtain this, the physical boundary conditions are challenging. However, it has turned out that the mentioned values of thermal conductivity are on the one hand higher than those of typical encapsulants (such as a mold compound) so that the thermal interface material efficiently removes heat from the package, and also allow to provide the thermal interface material with sufficient dielectric properties.

In an embodiment, the interface structure consists of a single layer. Therefore, it is dispensable to provide complex layer stacks of multiple layers for meeting the various thermomechanical and electrical properties at the same time. A single layer has turned out to be sufficient. This also reduces the effort for forming the interface structure.

In an embodiment, the interface structure may comprise at least one additive. The at least one additive may be selected from a group consisting of a flame retardant, a pigment, a stress modifier, an ion capturer and a release agent. A flame retardant may reduce the tendency of the interface structure to burn in the presence of excessive heat or even fire. The addition of a pigment may allow to adjust the color of the interface structure. By the addition of a stress modifier, the thermal stress in an interior of the electronic component may be adjusted. An ion capturer may capture charged particles in an interior of an electronic component so as to ensure a proper electric insulation of the interface structure. The provision of a release agent may promote the simple release of a cured interface structure out of a mold tool.

In an embodiment, the amount of the ceramic filler particles is in a range between 20 weight percent to 95 weight percent, in particular in a range between 40 weight percent to 70 weight percent (based on the total weight of the interface structure). When the amount of filler particles becomes too low, excessive shrinkage during curing of the polymer ceramic may occur. When the amount of filler particles becomes too large, the resulting viscosity of the polymer ceramic may render handling more difficult. It may be preferred that the major constituent of the interface structure are the filler particles. For instance, it is possible by providing a sufficiently large amount of filler particles in the polymer to obtain a high thermal conductivity so as to significantly contribute to the removal of heat of the electronic chip of the electronic component during operation. It is also possible to improve the dielectric reliability of the interface structure, i.e. to safely prevent an electric current to propagate along or through the interface structure. This may improve the electric reliability of the package or electronic component.

In an embodiment, the electronic component is configured as one of the group consisting of a leadframe connected power module, a Transistor Outline (TO) electronic component, a Quad Flat No Leads Package (QFN) electronic component, a Small Outline (SO) electronic component, a Small Outline Transistor (SOT) electronic component, and a Thin Small Outline Package (TSOP) electronic component. Therefore, the electronic component according to an exemplary embodiment is fully compatible with standard packaging concepts (in particular fully compatible with standard TO packaging concepts) and appears externally as a conventional electronic component, which is highly user-convenient. In an embodiment, the electronic component is configured as power module, for instance molded power module. For instance, an exemplary embodiment of the electronic component may be an intelligent power module (IPM).

In an embodiment, a carrier-type base body or a separate carrier on which the electronic chip is mounted may be a leadframe (for instance made of copper and/or copper alloy, aluminum and/or an aluminum alloy). A leadframe may be a metal structure inside a chip package that is configured for carrying signals or an electrical current from the electronic chip to the outside, and/or vice versa. The electronic chip inside the package or electronic component may be attached to the leadframe, and then one or more bond wires may be provided for attaching one or more pads of the electronic chip to one or more leads of the leadframe.

In an embodiment, the electronic component further comprises the above-mentioned heat dissipation body (which may be attached or may be to be attached to the interface structure) for dissipating heat generated by the electronic chip during operation of the electronic component. For example, the heat dissipation body may be a plate of a properly thermally conductive body, such as copper or aluminium or graphite, diamond, composite material and/or combinations of the mentioned and/or other materials, which may have cooling fins or the like to further promote dissipation of heat which can be thermally conducted from the electronic chip via the interface structure to the heat dissipation body. The removal of the heat via the heat dissipation body may further be promoted by a cooling fluid such as air or water (more generally a gas and/or a liquid) which may flow along the heat dissipation body externally of the electronic component.

In an embodiment, the electronic component is adapted for double-sided cooling. For example, a first interface structure may thermally couple the (for instance encapsulated) chip with a first heat dissipation body, whereas a second interface structure may thermally couple the chip with a second heat dissipation body.

In an embodiment, the electronic chip is configured as a power semiconductor chip. Thus, the electronic chip (such as a semiconductor chip) may be used for power applications for instance in the automotive field and may for instance have at least one integrated insulated-gate bipolar transistor (IGBT) and/or at least one transistor of another type (such as a MOSFET, a JFET, etc.) and/or at least one integrated diode. Such integrated circuit elements may be made for instance in silicon technology or based on wide-bandgap semiconductors (such as silicon carbide). A semiconductor power chip may comprise one or more field effect transistors, diodes, inverter circuits, half-bridges, full-bridges, drivers, logic circuits, further devices, etc.

As substrate or wafer forming the basis of the electronic chip(s), a semiconductor substrate, preferably a silicon substrate, may be used. Alternatively, a silicon oxide or another insulator substrate may be provided. It is also possible to implement a germanium substrate or a III-V-semiconductor material. For instance, exemplary embodiments may be implemented in GaN or SiC technology.

Furthermore, exemplary embodiments may make use of standard semiconductor processing technologies such as appropriate etching technologies (including isotropic and anisotropic etching technologies, particularly plasma etching, dry etching, wet etching), patterning technologies (which may involve lithographic masks), deposition technologies (such as chemical vapor deposition (CVD), plasma enhanced chemical vapor deposition (PECVD), atomic layer deposition (ALD), sputtering, etc.).

The above and other objects, features and advantages will become apparent from the following description and the appended claims, taken in conjunction with the accompanying drawings, in which like parts or elements are denoted by like reference numbers.

### Brief description of the drawings

The accompanying drawings, which are included to provide a further understanding of exemplary embodiments and constitute a part of the specification, illustrate exemplary embodiments.

In the drawings:
Figure 1 illustrates a cross-sectional view of an electronic component comprising an assembly unit according to an exemplary embodiment.
Figure 2 illustrates an assembly unit according to another exemplary embodiment functioning as a heat sink.
Figure 3 illustrates a cross-sectional view of an electronic component comprising an assembly unit according to another exemplary embodiment having a multi-layer chip carrier-type assembly unit.
Figure 4 illustrates a cross-sectional view of an electronic component comprising an assembly unit according to another exemplary embodiment having a patterned multi-layer multi-chip carrier-type assembly unit.

### Detailed description

The illustration in the drawing is schematically and not to scale.

Before exemplary embodiments will be described in more detail referring to the figures, some general considerations will be summarized based on which exemplary embodiments have been developed.

According to an exemplary embodiment, a polymer ceramic may be used as an interface material in an assembly unit or an electronic component. In particular, such a polymer ceramic interface material may be advantageously used for electronic components such as chip packages, for constructing a heat interface body, for forming a multilayer chip carrier, etc.

In particular, such an interface material may be used for removal of heat from an encapsulated chip while simultaneously providing an electric insulation of an exposed die pad or the like. Due to different requirements concerning these thermal interface materials, the selection of such materials is limited. Among others, such materials shall be provided as a very thin layer, should nevertheless be reliably electrically insulating even in the presence of high electric voltage, and should also be capable of withstanding high mechanical and thermal load. Moreover, it may be desired that such a thermal interface structure is made of a material having a high thermal conductivity so as to be capable of removing heat from an interior of the electronic component.

According to an exemplary embodiment, polymer ceramic materials are used for such interface structures. Thus, the excellent thermal conductivity of such materials as well as the reliable isolation strength may be efficiently used. At the same time, such a polymer ceramic may also be manufactured with reasonable effort. In contrast to conventionally use materials, the thermal stability of interface structures on the basis of polymer ceramic is high, so that a performance of the interface structure made of a polymer ceramic is very high as well. Thermal performance, dielectric performance and mechanical performance of polymer ceramic translates into a high thermal reliability, a high electric reliability and a high mechanical reliability of a correspondingly manufactured electronic component.

In terms of manufacturing such a polymer ceramic for use as a interface structure, it is for instance possible to apply a thin layer of polymer ceramic for example as a thin pre-extruded platelet. It is however also possible to provide a thin layer of a preform of polymer ceramic in a liquid form which can be subsequently cured. Thus, it may be easily possible with polymer ceramic materials to apply a thin layer of the polymer ceramic on an exposed die pad or any other surface. By tempering, it is possible to trigger cross-linking of the polymer ceramic or a preform thereof. If desired, the temperature may be raised to such a level that the polymer ceramic can be converted into a state in which a sub-portion of the polymer is also converted into a ceramic like material. Since the manufacture of the thermal interface material on the basis of a polymer ceramic can be carried out before die attachment on a carrier, it is also possible to use an increased curing temperature. As a result, the CTE (coefficient of thermal expansion) value of the polymer ceramic can be made even more similar to that of copper. As a result, the mechanical connection between the polymer ceramic based interface structure on the one hand and a base body (for instance a chip carrier such as a leadframe) on the other hand may be rendered more stable and temperature robust.

According to an embodiment, it is possible to sandwich an adhesion promoter as an intermediate layer between the base body and the polymer ceramic. This may further increase the robustness of the electronic component. This is a further advantage as compared to conventional approaches in which curing of an interface structure can be only made after die attach, because excessive temperatures may deteriorate or damage the electronic chip and/or its solder connection.

By adjusting the coefficient of thermal expansion of the interface structure to or close to the CTE value of base body (in particular carrier) material, for instance copper, a high reliability may be combined with a high performance.

Thus, an exemplary embodiment uses polymer ceramic composite material as interface structure for semiconductor packages. The interface structure material of polymer ceramic can be connected to an exposed surface of a base body by appropriate processing. For instance, it is possible to press a preform of the interface structure onto a target surface and connect it by triggering a chemical reaction. It is also possible to apply a paste or solution or suspension including the polymer ceramic and hardening or solidifying the polymer ceramic, for instance by evaporating a solvent. Also printing (if desired or required followed by a corresponding curing procedure) can be implemented for this purpose. In one embodiment, it is possible to attach the interface structure on the basis of polymer ceramic to a base body such as a chip carrier already prior to die attach, which increases the freedom of tempering.

In other embodiments, it may however also be possible to apply the polymer ceramic interface structure to a readily manufactured package or electronic component, i.e. after die attach.

A curing procedure of the polymer ceramic may allow adapting the properties of the interface structure so that the polymer ceramic may combine the advantages of ceramic and polymer materials synergetically.

**Figure 1** illustrates a cross-sectional view of an electronic component 100, which is embodied as a Transistor Outline (TO) package, according to an exemplary embodiment. According to Figure 1, the electronic component 100 is mounted on a mounting structure 132, here embodied as printed circuit board, for establishing an arrangement 130.

The mounting structure 132 comprises an electric contact 134 embodied as a plating in a through hole of the mounting structure 132. When the electronic component 100 is mounted on the mounting structure 132, an electronic chip 104 of the electronic component 100 is electrically connected to the electric contact 134 via an electrically conductive carrier 102, here embodied as a leadframe made of copper, of the electronic component 100.

The electronic component 100 comprises the electrically conductive carrier 102, the electronic chip 104 (which is here embodied as a power semiconductor chip) adhesively (see reference numeral 136) mounted on the carrier 102, and an encapsulant 106 (here embodied as mold compound) encapsulating part of the carrier 102 and part of the electronic chip 104. As can be taken from Figure 1, a pad on an upper main surface of the electronic chip 104 is electrically coupled to the carrier 102 via a bond wire 110.

During operation of the power package or electronic component 100, the power semiconductor chip in form of the electronic chip 104 generates a considerable amount of heat. At the same time, it must be ensured that any undesired current flow between a bottom surface of the electronic component 100 and an environment is reliably avoided.

For ensuring electrical insulation of the electronic chip 104 and removing heat from an interior of the electronic chip 104 towards an environment, an electrically insulating and thermally conductive interface structure 108 is provided which covers an exposed surface portion of the carrier 102 and a connected surface portion of the encapsulant 106 at the bottom of the electronic component 100.

The arrangement composed of the carrier 102, which can also be denoted as a base body 138, and the interface structure 108 attached to the base body 138 form an assembly unit 140 according to an exemplary embodiment.

The electrically insulating property of the interface structure 108 prevents undesired current flow even in the presence of high voltages between an interior and an exterior of the electronic component 100. The thermally conductive property of the interface structure 108 promotes a removal of heat from the electronic chip 104, via the electrically conductive carrier 102 (of thermally properly conductive copper), through the interface structure 108 and towards a heat dissipation body 112. The heat dissipation body 112, which may be made of a highly thermally conductive material such as copper or aluminum, has a plate body 114 adjacent to the interface structure 108 and has a plurality of cooling fins 116 extending from the plate body 114 and in parallel to one another so as to remove the heat towards the environment. When the heat dissipation body 112 is mounted on the rest of the electronic component 100 (for instance by a screw connection or by a clip, not shown), the interface between the interface structure 108 and the heat dissipation body 112 introduces only a small thermal resistance.

In the shown embodiment, the interface structure 108 is made of a polymer ceramic. More precisely and referring to a detail 195 in Figure 1, the polymer ceramic is manufactured of a silicon organic polymer 191 (such as polysiloxane) and inorganic filler particles 193 (for instance consisting of aluminum oxide). A thickness, d, of the planar layer-shaped interface structure 108 may be for example 200 µm. In view of the intrinsic properties of the constituents of the interface structure 108, the interface structure 108 has a high electric breakdown voltage and a thermal conductivity.

As shown in a detail 197 of Figure 1, the electronic component 100 may comprise one or more optional intermediate layers 199 between the carrier 102 and the interface structure 108. For example, the intermediate layer 199 may be an adhesion promoting layer.

In terms of the manufacture of the package or electronic component 100, it is possible to connect a preformed solid platelet of the polymer ceramic interface structure 108 to the carrier 102 and adjacent surface portions of the encapsulant 106, as shown in Figure 1. For instance, such a preformed platelet may be pressed on the carrier 102 and adjacent surface portions of encapsulant 106, and a chemical reaction for connecting the platelet to the carrier 102 and the encapsulant 106 may be triggered in this state. It is for instance also possible to connect the interface structure 108 to the carrier 102 (and optionally to the encapsulant 106) by an adhesive.

Alternatively, it is possible to apply a deformable preform of the polymer ceramic to the carrier 102 and optionally to adjacent surface portions of the encapsulant 106 and to subsequently cure the preform to thereby form solidified polymer ceramic. For example, the deformable preform may be a suspension. Curing the preform may be accomplished by evaporating a solvent of the preform. For instance, such a preform may be applied by printing to an exposed die pad surface of the carrier 102 including adjacent surface portions of encapsulant 106. The preform may be cured by tempering to thereby trigger cross-linking of the preform. More specifically, it may even be possible to heat the polymer ceramic up to a temperature for converting only part of the polymer ceramic in a ceramic state, whereas another part of the polymer ceramic may remain in a polymeric state. By heating the polymer ceramic up to a sufficiently high temperature to selectively change its material properties, it may be possible to reduce or even eliminate a mismatch between the coefficients of thermal expansion of the polymer ceramic in relation to at least part of the rest of the electronic component 100, in particular in relation to the copper carrier 102.

In a further alternative of the manufacturing method, the polymer ceramic covering the exposed surface portion of the carrier 102 may be provided before mounting the electronic chip 104 on the carrier 102. Alternatively, the polymer ceramic, to cover the exposed surface portion of the carrier 102, may be provided after mounting the electronic chip 104 on the carrier 102.

The use of a polymer ceramic material for forming the thermal interface structure 108 has the advantage that a high thermal conductivity for removing heat out of the electronic component 100 can be combined with a reliable electric insulation between an interior and an exterior of the electronic component 100, even in the presence of high voltages. Furthermore, the polymer ceramic has a high mechanical robustness and cannot be scratched away from the carrier 102. Furthermore, the polymer ceramic does not tend to delaminate and is therefore highly robust.

It is also possible to adjust the properties between the polymer ceramic on the one hand and the chip carrier 102 (and the other constituents of the electronic component 100) on the other hand so as to reduce the load acting on the electronic component 100 during thermal cycling. In particular, the coefficient of thermal expansion of the copper material of the leadframe-type chip carrier 102 on the one hand and the polymer ceramic material of the interface structure 108 on the other hand may be specifically adapted to one another so that a temperature increase will not result in excessive interior tensions of the electronic component 100.

Still referring to Figure 1, the arrangement composed of the carrier 102 and the interface structure 108 forms the assembly unit 140 which forms part, in turn, of the electronic component 100. This assembly unit 140 is composed of the base body 138 in form of the leadframe-type chip carrier 102 and the polymer ceramic layer-type interface structure 108. Although not shown in Figure 1, it is also possible to provide a similar assembly unit 140 by attaching an interface structure 108 on the leadframe-type base body 138, and to use such an assembly unit 140 as a separate member. Such a separate member in form of the assembly unit 140 may then be used for constructing electronic components of the type shown in Figure 1 or other electronic systems.

**Figure 2** illustrates an assembly unit 140 according to another exemplary embodiment.

According to Figure 2, the assembly unit 140 is composed of heat dissipation body 112, here constituting base body 138, to which a layer-shaped interface structure 108 is fixedly attached.

As an integral structure, the base body 138 (or heat dissipation body 112) and the interface structure 108 form the assembly unit 140 of Figure 2. For instance, the assembly unit 140 of Figure 2 may be attached as a whole to an exposed die pad of carrier 102 (and if desired to adjacent surface portions of encapsulant 106) of the electronic component 100 of Figure 1, as an alternative to the interface structure 108 fixedly connected to carrier 102 and the separately connectable heat dissipation body 112 of Figure 1.

In other words, the assembly unit 140 of Figure 2 comprises the heatsink-type base body 138 and the electrically insulating and thermally conductive interface structure 108 fixedly attached to the base body 138 and comprising the polymer ceramic. Thus, the assembly unit 140 of Figure 2 may be used as a separate member composed of heat dissipation body 112 and the interface structure 108. For instance, this separate member may be attached to an exposed die pad of carrier 102 of Figure 1. According to Figure 2, the interface structure 108 is integrally formed with the heatsink type base body 138.

While in the embodiment of Figure 1, the interface structure 108 is fixedly connected to the carrier 102 and the heats dissipation body 112 is provided as a separate body, it is possible in the alternative embodiment of Figure 2 that the interface structure 108 is fixedly connected to the heat dissipation body 112 and can be removably attached to the carrier 102 and the encapsulant 106.

**Figure 3** illustrates a cross-sectional view of an electronic component 100 according to another exemplary embodiment comprising a multi-layer assembly unit 140.

In contrast to the embodiment of Figure 1, the embodiment of Figure 3 comprises another type of assembly unit 140. In this embodiment, a carrier 102 (for instance a copper plate), the interface structure 108 of polymer ceramic, and the base body 138 (for instance a further copper plate) together form a planar triple-layer stack on which the electronic chip 104 is mounted.

Furthermore, a pad on an upper main surface of the electronic chip 104 is connected with the upper layer (i.e. carrier 102) of the assembly unit 140 by a bond wire 110. An encapsulant 106, for instance a mold compound, encapsulates the mentioned elements of electronic component 100 according to Figure 3.

When adjusting the degree of curing of the polymer ceramic of interface structure 108 appropriately, the CTE value of the polymer ceramic can be adjusted to be very similar to the CTE value of the copper material of carrier 102 as well as of base body 138. According to Figure 3, the layer stack is not patterned.

**Figure 4** illustrates a cross-sectional view of an electronic component 100 according to another exemplary embodiment comprising a patterned multi-layer assembly unit 140.

In contrast to the embodiment of Figure 3, the embodiment according to Figure 4 provides an assembly unit 140 in which the carrier 102 and the interface structure 108 are both configured as patterned layer on the continuous base body 138. Thus, two separate mounting regions may be defined, both of which carrying a respective electronic chip 104. In contrast to the embodiments of Figure 1 and Figure 3, no encapsulant 106 is provided in the electronic component 100 according to Figure 4. In another embodiment, such an encapsulant 106 may be provided for the embodiment of Figure 4 itself.

It should be noted that the term "comprising" does not exclude other elements or features and the "a" or "an" does not exclude a plurality. Also elements described in association with different embodiments may be combined. It should also be noted that reference signs shall not be construed as limiting the scope of the claims. Moreover, the scope of the present application is not intended to be limited to the particular embodiments of the process, machine, manufacture, composition of matter, means, methods and steps described in the specification. Accordingly, the appended claims are intended to include within their scope such processes, machines, manufacture, compositions of matter, means, methods, or steps.

## Claims

1. An assembly unit (140) for coupling with an electronic chip (104) of an electronic component (100), the assembly unit (140) comprising:
• a base body (138); and
• an electrically insulating and thermally conductive interface structure (108) attached to the base body (138) and comprising a cured polymer ceramic,
**characterized in that**
a coefficient of thermal expansion of the cured polymer ceramic is in a range between 7 ppm/K and 30 ppm/K, in particular in a range between 10 ppm/K and 20 ppm/K.

2. The assembly unit (140) according to claim 1, comprising one of the following features:
wherein the base body (138) is configured as a chip carrier (102) for carrying the electronic chip (104);
wherein the base body (138) is configured as a heat dissipation body (112) for dissipating heat;
comprising a carrier (102) arranged on the interface structure (108) so that the carrier (102), the interface structure (108) and the base body (138) together form a layer stack, wherein in particular at least one of the carrier (102) and the interface structure (108) is configured as patterned layer on the base body (138).

3. The assembly unit (140) according to claim 1 or 2, comprising at least one of the following features:
wherein the interface structure (108) is configured as a sheet, in particular as one of a planar sheet and a curved sheet;
wherein the interface structure (108) consists of the polymer ceramic;
wherein the interface structure (108) has a thickness (d) in a range between 50 µm and 600 µm, in particular in a range 100 µm and 400 µm;
comprising an intermediate layer (199) between the base body (138) and the interface structure (108).

4. The assembly unit (140) according to any of claims 1 to 3, wherein the polymer ceramic comprises a polymer (191) and ceramic filler particles (193) mixed with the polymer (191).

5. The assembly unit (140) according to claim 4, comprising at least one of the following features:
wherein the polymer (191), in particular silicon organic polymer, comprises at least one of the group consisting of polysiloxane, polycarbosilane, polysilazane, and polyborosilazane;
wherein the ceramic filler particles (193), in particular inorganic filler particles, comprise at least one of the group consisting of oxide ceramic, nitride ceramic, boron ceramic, silicate ceramic, and carbide ceramic;
wherein the ceramic filler particles (193) are selected from a group consisting of aluminum oxide, glass fibers, aluminum nitride, boron nitride, and titanium dioxide.

6. An electronic component (100), the electronic component (100) comprising:
• an assembly unit (140) according to any of claims 1 to 5;
• an electronic chip (104) on or above the assembly unit (140) .

7. The electronic component (100) according to claim 6, comprising an encapsulant (106) encapsulating at least part of the assembly unit (140) and/or at least part of the electronic chip (104).

8. A method of manufacturing an electronic component (100), the method comprising:
• forming an, in particular layer-shaped, electrically insulating and thermally conductive interface structure (108) comprising a polymer ceramic;
• connecting the interface structure (108) with a base body (138);
• thermally coupling an electronic chip (104) with the interface structure (108);
• curing a preform of the polymer ceramic to thereby at least partially cross-link a polymer (191) within which ceramic filler particles (193) are contained; and
• carrying out the curing so that the cross-linked polymer (191) is partially, but not entirely converted into a ceramic material.

9. The method according to claim 8, wherein the method comprises connecting a preformed platelet of the polymer ceramic to the base body (138), wherein in particular the method comprises pressing the preformed platelet on the base body (138) and triggering a reaction for connecting the platelet to the base body (138).

10. The method according to claim 8, wherein the method comprises applying a deformable preform of the polymer ceramic to the base body (138) and subsequently curing the preform to thereby form the polymer ceramic.

11. The method according to claim 10, comprising at least one of the following features:
wherein the deformable preform is selected from a group consisting of a liquid preform, a solution-type preform, and a paste-type preform;
wherein the method comprising curing the preform by evaporating a solvent of the preform to thereby convert the deformable preform into a solid polymer ceramic;
wherein the method comprises applying the preform by printing.

12. The method according to any of claims 8 to 11, comprising at least one of the following features:
wherein the method comprises controlling a curing of a preform of the polymer ceramic so that a coefficient of thermal expansion of the cured polymer ceramic is approached towards a coefficient of thermal expansion of the base body (138) by the curing;
wherein the method comprises controlling a curing of a preform of the polymer ceramic so that a coefficient of thermal expansion of the cured polymer ceramic is in a range between 7 ppm/K and 30 ppm/K, in particular in a range between 10 ppm/K and 20 ppm/K;
wherein the method comprises forming the polymer ceramic on the base body (138) before mounting the electronic chip (104) on or above the base body (138);
wherein the method comprises forming the polymer ceramic on the base body (138) after mounting the electronic chip (104) on or above the base body (138).

13. A method of using an interface material layer comprising a cured polymer ceramic for providing an electric isolation and a thermal coupling of an electronic chip (104) of an electronic component (100),
**characterized in that**
a coefficient of thermal expansion of the cured polymer ceramic is in a range between 7 ppm/K and 30 ppm/K, in particular in a range between 10 ppm/K and 20 ppm/K.

## Patentansprüche

1. Montageeinheit (140) zum Koppeln mit einem elektronischen Chip (104) einer elektronischen Komponente (100), wobei die Montageeinheit (140) Folgendes aufweist:
• einen Basiskörper (138); und
• eine elektrisch isolierende und thermisch leitfähige Schnittstellenstruktur (108), die an dem Basiskörper (138) angebracht ist und eine ausgehärtete Polymerkeramik aufweist,
**dadurch gekennzeichnet, dass**
ein Wärmeausdehnungskoeffizient der ausgehärteten Polymerkeramik in einem Bereich zwischen 7 ppm/K und 30 ppm/K, insbesondere in einem Bereich zwischen 10 ppm/K und 20 ppm/K liegt.

2. Montageeinheit (140) nach Anspruch 1, die eines der folgenden Merkmale aufweist:
wobei der Basiskörper (138) als ein Chipträger (102) zum Tragen des elektronischen Chips (104) konfiguriert ist;
wobei der Basiskörper (138) als ein Wärmeableitungskörper (112) zum Ableiten von Wärme konfiguriert ist;
die einen Träger (102) aufweist, der auf der Schnittstellenstruktur (108) angeordnet ist, so dass der Träger (102), die Schnittstellenstruktur (108) und der Basiskörper (138) zusammen einen Schichtstapel bilden, wobei insbesondere der Träger (102) und/oder die Schnittstellenstruktur (108) als eine strukturierte Schicht auf dem Basiskörper (138) konfiguriert ist.

3. Montageeinheit (140) nach Anspruch 1 oder 2, die mindestens eines der folgenden Merkmale aufweist:
wobei die Schnittstellenstruktur (108) als eine Platte, insbesondere als eine ebene Platte oder eine gekrümmte Platte, konfiguriert ist;
wobei die Schnittstellenstruktur (108) aus der Polymerkeramik besteht;
wobei die Schnittstellenstruktur (108) eine Dicke (d) in einem Bereich zwischen 50 µm und 600 um, insbesondere in einem Bereich zwischen 100 µm und 400 µm, aufweist;
die eine Zwischenschicht (199) zwischen dem Basiskörper (138) und der Schnittstellenstruktur (108) aufweist.

4. Montageeinheit (140) nach einem der Ansprüche 1 bis 3, wobei die Polymerkeramik ein Polymer (191) und mit dem Polymer (191) gemischte keramische Füllstoffpartikel (193) aufweist.

5. Montageeinheit (140) nach Anspruch 4, die mindestens eines der folgenden Merkmale aufweist:
wobei das Polymer (191), insbesondere siliziumorganisches Polymer, mindestens eines aus der Gruppe aufweist, die aus Polysiloxan, Polycarbosilan, Polysilazan und Polyborosilazan besteht;
wobei die keramischen Füllstoffpartikel (193), insbesondere anorganische Füllstoffpartikel, mindestens eines aus der Gruppe aufweisen, die aus Oxidkeramik, Nitridkeramik, Borkeramik, Silikatkeramik und Carbidkeramik besteht;
wobei die keramischen Füllstoffpartikel (193) aus einer Gruppe ausgewählt sind, die aus Aluminiumoxid, Glasfasern, Aluminiumnitrid, Bornitrid und Titandioxid besteht.

6. Elektronische Komponente (100), wobei die elektronische Komponente (100) Folgendes aufweist:
• eine Montageeinheit (140) nach einem der Ansprüche 1 bis 5;
• einen elektronischen Chip (104) auf oder über der Montageeinheit (140).

7. Elektronische Komponente (100) nach Anspruch 6, die eine Verkapselung (106) aufweist, die mindestens einen Teil der Montageeinheit (140) und/oder mindestens einen Teil des elektronischen Chips (104) verkapselt.

8. Verfahren zum Herstellen einer elektronischen Komponente (100), wobei das Verfahren Folgendes aufweist:
• Ausbilden einer, insbesondere schichtförmigen, elektrisch isolierenden und thermisch leitfähigen Schnittstellenstruktur (108), die eine Polymerkeramik aufweist;
• Verbinden der Schnittstellenstruktur (108) mit einem Basiskörper (138);
• thermisches Koppeln eines elektronischen Chips (104) mit der Schnittstellenstruktur (108);
• Aushärten einer Vorform der Polymerkeramik, um dadurch ein Polymer (191), in dem keramische Füllstoffpartikel (193) enthalten sind, zumindest teilweise zu vernetzen; und
• Durchführen des Aushärtens, so dass das vernetzte Polymer (191) teilweise, aber nicht vollständig in ein keramisches Material umgewandelt wird.

9. Verfahren nach Anspruch 8, wobei das Verfahren ein Verbinden eines vorgeformten Plättchens der Polymerkeramik mit dem Basiskörper (138) aufweist, wobei das Verfahren insbesondere ein Drücken des vorgeformten Plättchens auf den Basiskörper (138) und das Auslösen einer Reaktion zum Verbinden des Plättchens mit dem Basiskörper (138) aufweist.

10. Verfahren nach Anspruch 8, wobei das Verfahren ein Aufbringen einer verformbaren Vorform der Polymerkeramik auf den Basiskörper (138) und ein anschließendes Aushärten der Vorform aufweist, um dadurch die Polymerkeramik zu bilden.

11. Verfahren nach Anspruch 10, das mindestens eines der folgenden Merkmale aufweist:
wobei die verformbare Vorform aus einer Gruppe ausgewählt ist, die aus einer flüssigen Vorform, einer Vorform vom Lösungstyp und einer Vorform vom Pastentyp besteht;
wobei das Verfahren ein Aushärten der Vorform durch Verdampfen eines Lösungsmittels der Vorform aufweist, um dadurch die verformbare Vorform in eine feste Polymerkeramik umzuwandeln;
wobei das Verfahren ein Aufbringen der Vorform durch Drucken aufweist.

12. Verfahren nach einem der Ansprüche 8 bis 11, das mindestens eines der folgenden Merkmale aufweist:
wobei das Verfahren ein Steuern eines Aushärtens einer Vorform der Polymerkeramik aufweist, so dass ein Wärmeausdehnungskoeffizient der ausgehärteten Polymerkeramik durch das Aushärten einem Wärmeausdehnungskoeffizienten des Basiskörpers (138) angenähert wird;
wobei das Verfahren ein Steuern eines Aushärtens einer Vorform der Polymerkeramik aufweist, so dass ein Wärmeausdehnungskoeffizient der ausgehärteten Polymerkeramik in einem Bereich zwischen 7 ppm/K und 30 ppm/K, insbesondere in einem Bereich zwischen 10 ppm/K und 20 ppm/K liegt;
wobei das Verfahren ein Ausbilden der Polymerkeramik auf dem Basiskörper (138) vor einem Montieren des elektronischen Chips (104) auf oder über dem Basiskörper (138) aufweist;
wobei das Verfahren ein Ausbilden der Polymerkeramik auf dem Basiskörper (138) nach einem Montieren des elektronischen Chips (104) auf oder über dem Basiskörper (138) aufweist.

13. Verfahren zum Verwenden einer Schnittstellenmaterialschicht, die eine ausgehärtete Polymerkeramik aufweist, zum Bereitstellen einer elektrischen Isolation und einer thermischen Kopplung eines elektronischen Chips (104) einer elektronischen Komponente (100),
**dadurch gekennzeichnet, dass**
ein Wärmeausdehnungskoeffizient der ausgehärteten Polymerkeramik in einem Bereich zwischen 7 ppm/K und 30 ppm/K, insbesondere in einem Bereich zwischen 10 ppm/K und 20 ppm/K liegt.

## Revendications

1. Une unité (140) d'assemblage à relier à une puce (104) électronique d'un composant (100) électronique, l'unité (140) d'assemblage comprenant :
• un corps (138) de base ; et
• une structure (108) d'interface isolante électriquement et conductrice thermiquement fixée au corps (138) de base et comprenant une céramique polymère durcie,
**caractérisée en ce qu'**
un coefficient de dilatation thermique de la céramique polymère durcie est dans une plage entre 7 ppm/K et 30 ppm/K, en particulier dans une plage entre 10 ppm/K et 20 ppm/K.

2. L'unité (140) d'assemblage suivant la revendication 1, comprenant l'une des caractéristiques suivantes :
dans laquelle le corps (138) de base est configuré en support (102) de puce pour supporter la puce (104) électronique ;
dans laquelle le corps (138) de base est configuré en corps (112) de dissipation de la chaleur pour dissiper de la chaleur ;
comprenant un support (102) disposé sur la structure (108) d'interface de manière à ce que le support (102), la structure (108) d'interface et le corps (138) de base forment ensemble un empilement de couches, dans lequel en particulier au moins l'un du support (102) et de la structure (108) d'interface est configuré en couche à motifs sur le corps (138) de base.

3. L'unité (140) d'assemblage suivant la revendication 1 ou 2, comprenant au moins l'une des caractéristiques suivantes :
dans laquelle la structure (108) d'interface est configurée sous la forme d'une feuille, en particulier sous la forme de l'une d'une feuille plane et d'une feuille incurvée ;
dans laquelle la structure (108) d'interface consiste en la céramique polymère ;
dans laquelle la structure (108) d'interface a une épaisseur (d) dans une plage comprise entre 50 µm et 600 µm, en particulier dans une plage comprise entre 100 µm et 400 µm ;
comprenant une couche (199) intermédiaire entre le corps (138) de base et la structure (108) d'interface.

4. L'unité (140) d'assemblage suivant l'une quelconque des revendications 1 à 3, dans laquelle la céramique polymère comprend un polymère (191) et des particules (193) céramiques de charge mélangées au polymère (191).

5. L'unité (140) d'assemblage suivant la revendication 4, comprenant au moins l'une des caractéristiques suivantes :
dans laquelle le polymère (191), en particulier un polymère organique du silicium, comprend au moins l'un du groupe consistant en les polysiloxane, les polycarbosilane, les polysilazane et les polyborosilazane ;
dans laquelle les particules (193) céramiques de charge, en particulier des particules minérales de charge, comprennent au moins l'un du groupe consistant en une céramique d'oxyde, une céramique de nitrure, une céramique de bore, une céramique de silicate et une céramique de carbure ;
dans laquelle les particules (193) céramiques de charge sont choisies dans le groupe consistant en l'oxyde d'aluminium, les fibres de verre, le nitrure d'aluminium, le nitrure de bore et le dioxyde de titane.

6. Un composant (100) électronique, le composant (100) électronique comprenant :
• une unité (140) d'assemblage suivant l'une quelconque des revendications 1 à 5 ;
• une puce (104) électronique sur ou au-dessus de l'unité (140) d'assemblage.

7. Le composant (100) électronique suivant la revendication 6, comprenant un agent (106) d'enrobage enrobant au moins une partie de l'unité (140) d'assemblage et/ou au moins une partie de la puce (104) électronique.

8. Un procédé de fabrication d'un composant (100) électronique, le procédé comprenant :
• former sur, en particulier conformée en couche, une structure (108) d'interface isolante électriquement et conductrice thermiquement comprenant une céramique polymère ;
• relier la structure (108) d'interface à un corps (138) de base ;
• coupler thermiquement une puce (104) électronique à la structure (108) d'interface ;
• durcir une ébauche de la céramique polymère pour ainsi réticuler au moins en partie un polymère (191) au sein duquel des parties (193) céramiques de charge sont contenues ; et
• effectuer le durcissement de manière à transformer partiellement, mais non entièrement, le polymère (191) réticulé en un matériau céramique.

9. Le procédé suivant la revendication 8, dans lequel le procédé comprend relier une plaquette préformée de la céramique polymère au corps (138) de base, dans lequel en particulier le procédé comprend presser la plaquette préformée sur le corps (138) de base et déclencher une réaction pour relier la plaquette au corps (138) de base.

10. Le procédé suivant la revendication 8, dans lequel le procédé comprend appliquer une ébauche déformable de la céramique polymère au corps (138) de base et durcir ensuite l'ébauche pour former ainsi la céramique polymère.

11. Le procédé suivant la revendication 10, comprenant au moins l'une des caractéristiques suivantes :
dans lequel l'ébauche déformable est choisie dans un groupe consistant en une ébauche liquide, en une ébauche de type solution et en une ébauche de type pâte ;
dans lequel le procédé comprend durcir l'ébauche en évaporant un solvant de l'ébauche pour transformer ainsi l'ébauche déformable en une céramique polymère solide ;
dans lequel le procédé comprend appliquer l'ébauche par impression.

12. Le procédé suivant l'une quelconque des revendications 8 à 11, comprenant au moins l'une des caractéristiques suivantes :
dans lequel le procédé comprend régler un durcissement d'une ébauche de la céramique polymère de manière à ce qu'un coefficient de dilatation thermique de la céramique polymère durcie tende par le durcissement vers un coefficient de dilation thermique du corps (138) de base;
dans lequel le procédé comprend régler un durcissement d'une ébauche de la céramique polymère, de manière à ce qu'un coefficient de dilatation thermique de la céramique polymère durcie soit dans une plage entre 7 ppm/K et 30 ppm/K, en particulier dans une plage entre 10 ppm/K et 20 ppm/K ;
dans lequel le procédé comprend former la céramique polymère sur le corps (138) de base avant de monter la puce (104) électronique sur ou au-dessus du corps (138) de base ;
dans lequel le procédé comprend former la céramique polymère sur le corps (138) de base après avoir monté la puce (104) électronique sur ou au-dessus du corps (138) de base.

13. Un procédé d'utilisation d'une couche de matériau d'interface comprenant une céramique polymère durcie pour donner une isolation électrique et un couplage thermique d'une puce (104) électronique d'un composant (100) électronique, **caractérisé en ce qu'**
un coefficient de dilatation thermique de la céramique polymère durcie est dans une plage entre 7 ppm/K et 30 ppm/K, en particulier dans une plage entre 10 ppm/K et 20 ppm/K.
